(19) **Europäisches Patentamt / European Patent Office / Office européen des brevets**

(11) **EP 3 899 561 B1**

(12) **FASCICULE DE BREVET EUROPEEN**

(45) Date de publication et mention
de la délivrance du brevet:
**14.02.2024 Bulletin 2024/07**

(21) Numéro de dépôt: **19816329.7**

(22) Date de dépôt: **09.12.2019**

(51) Classification Internationale des Brevets (IPC):
*G01R 31/367* (2019.01)    *G01R 31/382* (2019.01)
*G01R 31/385* (2019.01)    *G01R 31/392* (2019.01)

(52) Classification Coopérative des Brevets (CPC):
**G01R 31/392; G01R 31/367; G01R 31/382;
G01R 31/385; Y02E 60/10**

(86) Numéro de dépôt international:
**PCT/EP2019/084262**

(87) Numéro de publication internationale:
**WO 2020/126623 (25.06.2020 Gazette 2020/26)**

(54) **SANTE D'UNE BATTERIE**

**GESUNDHEITSZUSTAND EINER BATTERIE**

**STATE OF HEALTH OF A BATTERY**

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **17.12.2018 FR 1873046**

(43) Date de publication de la demande:
**27.10.2021 Bulletin 2021/43**

(73) Titulaire: **Electricité de France**
**75008 Paris (FR)**

(72) Inventeurs:
• **HASCOAT, Aurélien**
**77300 FONTAINEBLEAU (FR)**

• **TORCHEUX, Laurent**
**91330 YERRES (FR)**
• **GOMBERT, Luc**
**77169 BOISSY LE CHATEL (FR)**
• **HITA, Alain**
**77300 FONTAINEBLEAU (FR)**

(74) Mandataire: **Plasseraud IP**
**66, rue de la Chaussée d'Antin**
**75440 Paris Cedex 09 (FR)**

(56) Documents cités:
| | |
|---|---|
| EP-A1- 2 746 797 | EP-A1- 2 944 970 |
| EP-A1- 3 258 282 | WO-A1-2015/086753 |
| FR-A1- 3 020 142 | JP-A- S58 140 969 |
| US-A1- 2016 322 675 | |

## Description

### Domaine technique

L'invention relève du domaine des batteries, et plus particulièrement du diagnostic de cellules électrochimiques, ou accumulateurs, ayant déjà été utilisés.

### Technique antérieure

Il est connu de modéliser les pertes de performances des cellules électrochimiques au fil du temps en fonction de leur utilisation. Cela implique de connaitre les divers paramètres de l'utilisation. En pratique, les paramètres d'utilisation, ou l'historique, sont souvent inconnus. Il existe donc un besoin de qualification et de quantification des dégradations de performances d'une cellule électrochimique, ou d'un ensemble de cellules tel qu'une batterie, dont les conditions d'utilisation antérieure sont inconnues ou incertaines. L'un des paramètres de performance d'une cellule électrochimique est une variable appelée « état de santé », ou SOH pour « *State Of Health* ». Ce paramètre, sans unité et exprimé généralement en pourcentage, se définit comme le rapport de la capacité électrique réelle $C_{rea}$ de la cellule sur la capacité électrique nominale $C_{nom}$ de la même cellule. L'équation ci-après représente ce paramètre :

[Math. 1]

$$SOH = \frac{C_{rea}}{C_{nom}} \times 100$$

Il est possible de mesurer l'état de santé d'une cellule électrochimique en déchargeant totalement la cellule pour en mesurer la capacité à un courant suffisamment faible pour que les effets parasites puissent être considérés négligeables. De tel effets parasites sont variables au cours du vieillissement de la cellule mais correspondent généralement aux phénomènes qui transforment la capacité stockée en énergie non électrique et conduisent à une capacité réelle inférieure à la capacité nominale. Typiquement, une telle mesure implique une décharge des batteries pendant trois heures, sous courant faible, comme cela est prévu par certaines normes, telles que la norme ISO 12405-4:2018.

Effectuer ce type de diagnostic est moins long et coûteux que de démanteler les batteries mais reste long, et donc coûteux. Il est théoriquement possible d'effectuer d'autres types de tests, notamment plus rapides et sous courant fort. Néanmoins, des résultats ainsi obtenus ne seraient pas comparables à ceux obtenus selon les normes en vigueur. Or, en pratique, obtenir un indicateur qui n'est pas comparable aux autres indicateurs présente un intérêt très limité, voir nul. Créer un indicateur hors de la norme va à l'encontre même du but d'une norme, à savoir disposer d'un référentiel commun. Créer un nouvel indicateur n'est donc *a priori* pas souhaitable.

La demande de brevet française dont le numéro de publication est FR 3 020 142 A1 décrit un procédé de calibration d'une batterie permettant de mémoriser des données de calibration liées à son état de santé. La demande de brevet européenne dont le numéro de publication est EP 2 746 797 A1 décrit une méthode de caractérisation de paramètres d'un modèle équivalent à un accumulateur. Néanmoins, aucun de ces documents ne propose d'établir une correspondance entre des décharges rapides et lentes.

L'invention vient améliorer la situation.

### Exposé de l'invention

Il est proposé un procédé de construction d'un abaque de correspondance entre une décharge rapide et une décharge lente pour une mesure d'usure d'au moins une cellule électrochimique. Le procédé comprend une phase de mesure et une phase de vieillissement, la phase de mesure incluant elle-même une séquence de conditionnement suivie d'une séquence de caractérisation. Au cours de la séquence de conditionnement les opérations suivantes sont mises en oeuvre :

> a. charger l'au moins une cellule à un niveau de courant de référence jusqu'à atteindre une tension prédéterminée de fin de charge ;
> b. relaxer l'au moins une cellule pendant une première durée ;
> c. décharger l'au moins une cellule au niveau de courant de référence jusqu'à atteindre une tension prédéterminée de fin de décharge ;
> d. relaxer l'au moins une cellule pendant une deuxième durée.

Au cours de la séquence de caractérisation, les opérations suivantes sont mises en oeuvre :

    i. charger l'au moins une cellule au niveau de courant de référence jusqu'à atteindre une tension prédéterminée de fin de charge ;
    ii. relaxer l'au moins une cellule pendant une troisième durée ;
    iii. décharger l'au moins une cellule à un niveau de courant sélectionné jusqu'à atteindre une tension prédéterminée de fin de décharge ;
    iv. relaxer l'au moins une cellule pendant une quatrième durée.

La séquence de caractérisation est réitérée au moins une fois en augmentant chaque fois la valeur dudit niveau de courant sélectionné par rapport à l'itération précédente.

Le temps de chaque décharge est mesuré de sorte que la capacité réelle de la cellule peut être déduite à chaque décharge en fonction de l'intensité de chaque décharge et du temps de décharge mesuré.

La phase de vieillissement comprend une alternance de charges et décharges dépourvue de relaxation intermédiaire et au niveau de courant de référence.

La phase de mesure est réitérée au moins une fois avec un niveau de courant de référence différent de celui de l'itération précédente, la phase de vieillissement étant mise en oeuvre avant chaque réitération de la phase de mesure, de sorte qu'une capacité réelle est obtenue pour une pluralité de couples de paramètres, chaque couple de paramètres incluant un niveau de courant sélectionnés et un niveau de courant de référence.

Selon un autre aspect, il est proposé un procédé de détermination d'un état d'usure d'une cellule électrochimique selon la revendication 6.

Selon un autre aspect, il est proposé un banc d'essai agencé de manière à pouvoir y connecter les bornes électriques d'une cellule électrochimique ou d'un ensemble de cellules électrochimiques. Le banc comprend un module de commande apte à imposer un courant et une tension choisis entre lesdites bornes et un module de mesure apte à mesurer le courant et la tension entre lesdites bornes. Le module de commande et le module de mesure sont conjointement agencés pour mettre en oeuvre l'un au moins des procédés décrits dans les présentes.

Selon un autre aspect, il est proposé un programme informatique comportant des instructions pour la mise en oeuvre de tout ou partie d'un procédé tel que défini dans les présentes lorsque ce programme est exécuté par un processeur. Selon un autre aspect de l'invention, il est proposé un support d'enregistrement non transitoire, lisible par un ordinateur, sur lequel est enregistré un tel programme.

Les caractéristiques exposées dans les paragraphes suivants peuvent, optionnellement, être mises en oeuvre. Elles peuvent être mises en oeuvre indépendamment les unes des autres ou en combinaison les unes avec les autres :

L'un au moins des niveaux de courant de référence peut être égal au tiers du courant électrique permettant la décharge totale de la cellule électrochimique en une heure.

D'une première séquence de caractérisation à la dernière, la valeur du niveau de courant sélectionné peut varier d'un courant faible inférieur ou égal au cinquième du courant électrique permettant la décharge totale de la cellule électrochimique en une heure jusqu'à un courant fort supérieur ou égal au quintuple du courant électrique permettant la décharge totale de la cellule électrochimique en une heure.

Les durées de relaxation peuvent être inférieures ou égales à 120 minutes.

La capacité réelle de la cellule peut être déduite à chaque décharge par multiplication de l'intensité de chaque décharge par le temps de décharge mesuré ou par application de l'équation suivante :

[Math. 2]

$$C_V = \int_t i(t) \times dt$$

Le niveau de courant fort peut être supérieur au tiers du courant électrique permettant la décharge totale de la cellule électrochimique en une heure et le niveau de courant faible peut être inférieur ou égal au tiers du courant électrique permettant la décharge totale de la cellule électrochimique en une heure.

**Brève description des dessins**

D'autres caractéristiques, détails et avantages de l'invention apparaîtront à la lecture de la description détaillée ci-après, et à l'analyse des dessins annexés, sur lesquels :

**Fig. 1**

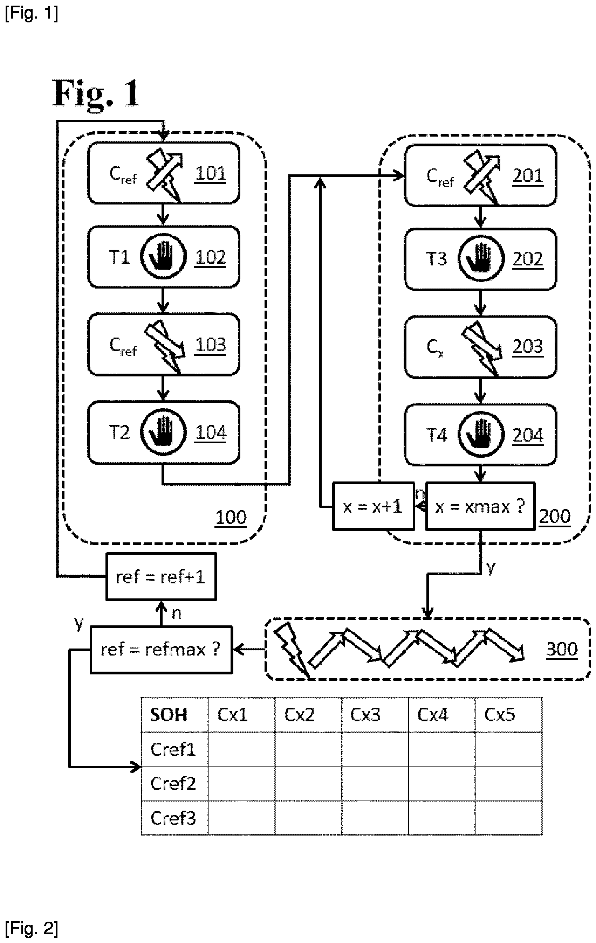

[Fig. 1] montre un organigramme d'un procédé selon un mode de réalisation de l'invention ;

**Fig. 2**

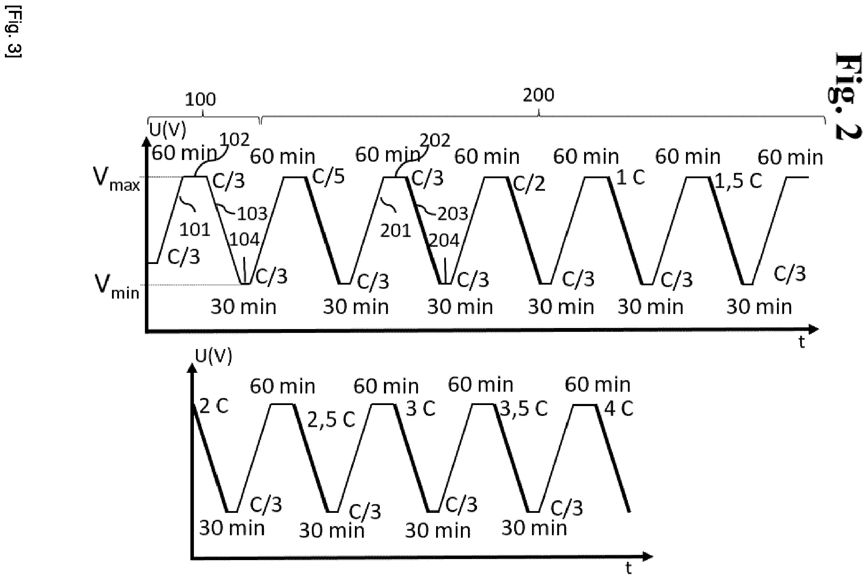

[Fig. 2] montre un exemple d'évolution d'une tension au cours de la mise en oeuvre d'un mode de réalisation de l'invention ;

**Fig. 3**

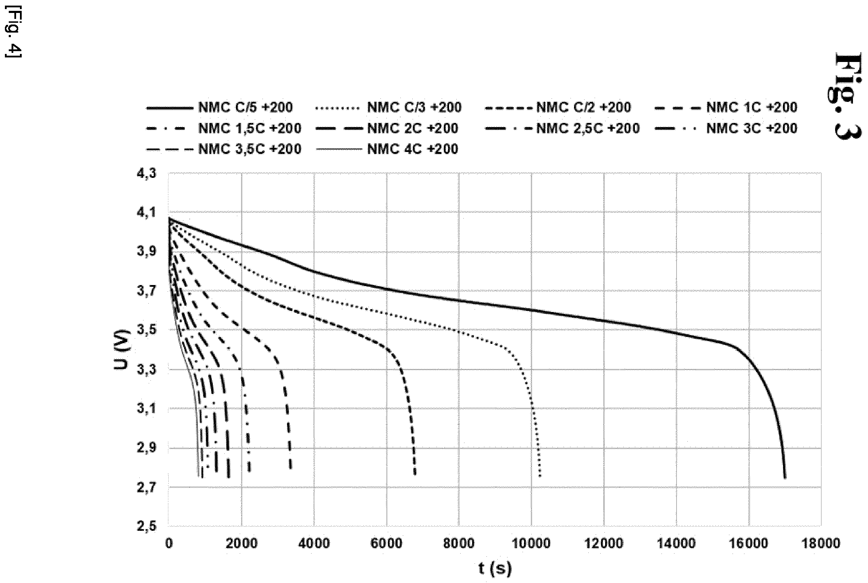

[Fig. 3] montre un exemple d'évolution de tension au fil du temps à divers niveaux de courant d'une cellule électrochimique ;

**Fig. 4**

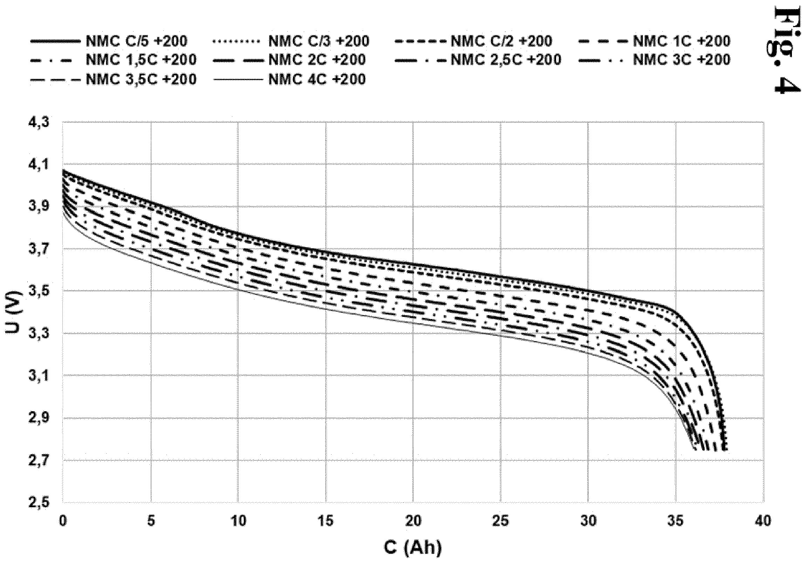

[Fig. 4] montre un exemple de relation tension-capacité à divers niveaux de courant d'une cellule électrochimique ;

**Description des modes de réalisation**

Les dessins et la description ci-après contiennent, pour l'essentiel, des éléments de caractère certain. Ils pourront donc non seulement servir à mieux faire comprendre la présente invention, mais aussi contribuer à sa définition, le cas échéant.

Dans la suite, et afin de ne pas complexifier inutilement le texte, il est fait référence à « une cellule » sur laquelle sont mis en oeuvre les procédés. Le lecteur comprendra néanmoins qu'on entend par « cellule » soit une cellule électrochimique isolée, soit un jeu de plusieurs cellules électrochimiques assemblées les unes avec les autres et formant ce qu'il est courant d'appeler une pile ou une batterie.

Dans la suite, il est fait mention de « niveau de courant ». On entend dans ce cas définir une valeur de courant de charge ou décharge d'une cellule.

Dans les exemples décrits ici, les essais ont été réalisés sur des cellules de technologie Lithium-ion utilisées dans le contexte d'une automobile électrique. Les cellules présentent une tension habituellement comprise entre 2,5V et 3,4V et présentent en moyenne un niveau de décharge d'environ 3V. Les exemples chiffrés correspondent à un tel contexte. L'invention ne saurait être limitée au domaine des automobiles électriques ou même au domaine des cellules de technologie Lithium-Ion et peut être transposable à d'autres domaines tels que celui des technologies NiMH, si besoin en adaptant les ordres de grandeur des valeurs d'exemple.

Il est maintenant fait référence à la [Fig. 1], sur laquelle un mode de réalisation d'un procédé de construction d'un abaque est représenté, et à la [Fig. 2] représentant une partie de l'évolution de la tension aux bornes de la cellule au cours de la mise en oeuvre du procédé. L'abaque permet ensuite d'assurer une correspondance entre une décharge rapide et une décharge lente pour une mesure d'usure d'une cellule électrochimique. Grâce à un tel abaque, il devient possible de déterminer le comportement de la cellule dans le cas théorique où elle serait soumise à des décharges lentes alors même que, en pratique, seules des décharges rapides sont mises en oeuvre.

Le procédé comprend une phase de mesure et une phase de vieillissement 300, la phase de mesure incluant elle-même une séquence de conditionnement 100 suivie d'une séquence de caractérisation 200.

La séquence de conditionnement 100 peut être décomposée selon les opérations suivantes :

a. charger 101 l'au moins une cellule à un niveau de courant de référence $C_{ref}$ ;
b. relaxer 102 l'au moins une cellule pendant une première durée T1 ;
c. décharger 103 l'au moins une cellule au niveau de courant de référence $C_{ref}$ ;
d. relaxer 104 l'au moins une cellule pendant une deuxième durée T2.

Le courant de référence, ou régime de courant de référence, est une valeur d'intensité sélectionnée (en Ampères) à laquelle est soumise la cellule pendant les opérations correspondantes. Dans les exemples décrits ici, le courant de référence est exprimé comme un multiple du courant électrique C permettant la décharge totale de la cellule électrique en une heure. Le courant C est le régime nominal de courant correspondant à la capacité d'une décharge d'une heure. Par exemple, un courant de référence noté « C/5 » équivaut au cinquième du courant nominal C.

Comme cela apparait sur la [Fig. 1], la séquence de conditionnement 100 incluant les opérations 101, 102, 103, 104 peut être réitérée au cours du procédé. Au cours d'une séquence, le niveau de courant de référence $C_{ref}$ reste constant. En revanche, cette valeur change d'une itération à l'autre de la séquence de conditionnement 100. Notamment, lorsque la phase de mesure est réitérée au moins une fois, elle l'est avec un niveau de courant de référence $C_{ref}$ différent de celui de l'itération précédente. Par exemple, le niveau de courant de référence $C_{ref}$ est augmenté d'une itération à la suivante.

Dans les exemples décrits ici, l'un au moins des niveaux de courant de référence $C_{ref}$ est égal au tiers C/3 du courant électrique C permettant la décharge totale de la cellule électrique en une heure. Le niveau de courant de référence C/3 correspond au niveau de courant imposé dans certaines au moins des normes d'essai des cellules électrochimiques. Ainsi, disposer d'un Abaque pour lequel le niveau de courant de référence C/3 est l'un des niveaux de courant de référence disponible facilite la conversion des résultats en des valeurs comparables à celles obtenues selon la norme, y compris à des valeurs obtenues par des essais distincts de ceux des procédés décrits ici.

Dans les exemples décrits ici, les durées de relaxation T1 et T2 sont chacune inférieure ou égale à 120 minutes et de préférence inférieure ou égale à 60 minutes. Dans l'exemple représenté sur la [Fig. 2], la première durée de relaxation T1 est égale à 60 minutes tandis que la deuxième durée de relaxation T2 est égale 30 minutes.

Dans les exemples décrits ici, les opérations de charge 101 et décharge 103 sont mises en oeuvre jusqu'à atteindre une tension respectivement de fin de charge $V_{max}$ et de fin de décharge $V_{min}$. Autrement dit, on vise ici une « charge complète », respectivement une « décharge complète ». Le chargement/déchargement est considéré comme terminé lorsque la tension aux bornes de la cellule atteint une valeur nominale (en Volts) correspondant au niveau de charge/décharge nominal de la cellule.

La séquence de caractérisation 200 peut être décomposées selon les opérations suivantes :

i. charger 201 l'au moins une cellule au niveau de courant de référence $C_{ref}$ ;
ii. relaxer 202 l'au moins une cellule pendant une troisième durée T3 ;
iii. décharger 203 l'au moins une cellule à un niveau de courant sélectionné $C_x$ ;
iv. relaxer 204 l'au moins une cellule pendant une quatrième durée T4.

Le niveau de courant de référence $C_{ref}$ est identique à celui de la séquence de conditionnement 100 qui précède immédiatement la séquence de caractérisation 200.

Dans les exemples décrits ici, les durées de relaxation T3 et T4 sont chacune inférieure ou égale à 120 minutes et de préférence inférieure ou égale à 60 minutes. Dans l'exemple représenté sur la [Fig. 2], la troisième durée de relaxation T3 est égale à 60 minutes tandis que la quatrième durée de relaxation T4 est égale 30 minutes.

Le courant sélectionné $C_x$ est une valeur d'intensité sélectionnée (en Ampères) à laquelle est soumise la cellule pendant les opérations (203) correspondantes. Dans les exemples décrits ici, le courant sélectionné $C_x$ est, lui aussi, exprimé comme un multiple du courant électrique C permettant la décharge totale de la cellule électrique en une heure. Comme cela apparait sur la [Fig. 1], la séquence de caractérisation 200 incluant les opérations 201, 202, 203, 204 peut être réitérée au cours du procédé. Le niveau de courant sélectionné $C_x$ varie d'une itération à l'autre de la séquence de caractérisation 200.

Dans les exemples décrits ici, d'une première séquence de caractérisation à la dernière, la valeur du niveau de courant sélectionné $C_x$ augmente d'un courant faible à un courant fort. Par exemple, le niveau de courant sélectionné $C_x$ varie d'un courant faible inférieur ou égal au cinquième C/5 du courant électrique C permettant la décharge totale de la cellule électrique en une heure jusqu'à un courant fort supérieur ou égal au quintuple 5C du courant nominal électrique C permettant la décharge totale de la cellule électrique en une heure. Dans l'exemple représenté en [Fig. 2], la valeur du niveau de courant sélectionné $C_x$ prend successivement les valeurs suivantes : C/5 ; C/3 ; C/2 ; C ; 1,5C ; 2C ; 2,5C ; 3C ; 3,5C ; 4C ; 5C. En variante, des niveaux de courants plus élevés peuvent être mis en oeuvre.

Dans les exemples décrits ici, les opérations de charge 201 et décharge 203 sont mises en oeuvre jusqu'à atteindre une tension respectivement de fin de charge $V'_{max}$ et de fin de décharge $V'_{min}$. Autrement dit, on vise ici une « charge complète », respectivement une « décharge complète ». Le chargement/déchargement est considéré comme terminé lorsque la tension aux bornes de la cellule atteint une valeur nominale (en Volts) correspondant au niveau de charge/décharge nominal de la cellule. Le temps nécessaire pour atteindre cette tension diminue naturellement lorsque le courant augmente. La perte de capacité restituée lorsque le courant de décharge augmente est visible dans la [Fig. 4]. Des essais en laboratoire suivant le même protocole sont pratiqués à différents stades de vieillissement sur les mêmes cellules afin de suivre l'effet du courant au cours du temps.

Lorsque le nombre d'itérations de la séquence de caractérisation 200 a atteint un maximum, la phase de vieillissement 300 est mise en oeuvre. Les itérations de la séquence de caractérisation 200 permettent de prendre en compte expérimentalement l'effet du courant fort sur la capacité mesurée, en augmentant progressivement le régime de courant à chaque itération. Cela permet aussi de considérer l'énergie de décharge en négligeant l'échauffement (régime à courant faible) et d'identifier une valeur de courant fort (par exemple jusqu'à 5C) pour lequel :

- les phénomènes électrochimiques sont essentiellement accélérés (par analyse des pentes de décharge) ;
- les dégradations causées par la décharge rapide est négligeable au regard de l'étude.

Autrement dit, la séquence de caractérisation 200 permet de prendre en compte les effets parasites dus à l'utilisation de courant fort par rapport à l'utilisation de courant faible.

La phase de vieillissement comprend une alternance de charges et décharges. Les alternances de charges et décharges sont dépourvues de relaxation intermédiaire. La phase de vieillissement est effectuée au niveau du courant de référence $C_{ref}$. La valeur du niveau de courant de référence $C_{ref}$ est identique à celle de la séquence de caractérisation 200 qui précède. Le nombre de cycles charge-décharge peut, par exemple, être compris entre 1 et 5000, par exemple environ 200 cycles. Le but de la phase de vieillissement est, comme son nom l'indique, de réduire artificiellement les performances de la cellule en accélérant son usure par rapport à un usage « normal », c'est-à-dire à réduire sa durée de vie, son SOH. Pour atteindre cet effet, le nombre de cycles peut être adapté en fonction du type de cellules. La phase de vieillissement 300 est mise en oeuvre avant chaque réitération de la phase de mesure 100-200. Ainsi, des mesures sont obtenues à différents stades de vieillissement de la cellule.

Les phases de vieillissement 300 permettent de mesurer expérimentalement les effets de la diminution du SOH, et donc d'obtenir des mesures équivalentes pour différents niveaux d'usure d'une cellule. Ainsi, la combinaison de la phase de mesure 100-200 et de la phase de vieillissement 300 permet de prendre en compte, de façon expérimentale, l'ensemble des mécanismes parasites variables au cours de la durée de vie d'une cellule.

Au cours de chaque séquence de caractérisation 200, en particulier au cours de l'opération 203, le temps de chaque décharge ainsi que le courant électrique durant la décharge sont mesurés. Ainsi, la capacité réelle $C_v$ (ou capacité restituée) de la cellule peut être déduite à chaque décharge, par exemple par multiplication de l'intensité de chaque décharge par le temps de décharge mesuré. On obtient une capacité réelle $C_v$ pour une pluralité de couples de paramètres, chaque couple de paramètres incluant un niveau de courant sélectionnés $C_x$ et un niveau de courant de référence $C_{ref}$. Dans des cas où l'évolution du courant au cours du temps est complexe (par exemple non constante), la capacité peut être calculée par une intégrale sur le temps plutôt que par une simple multiplication. Ci-avant, on propose d'utiliser la valeur de la capacité réelle restituée comme valeurs de comparaison. Néanmoins, d'autres valeurs déduites des mesures peuvent être obtenues et utilisées comme valeurs de comparaison. Par exemple, l'énergie restituée peut former une telle grandeur de comparaison.

On peut déduire directement de l'équation [Math. 1] ci-avant l'équation suivante pour deux régimes quelconques, par exemple sous un courant de référence $C_{ref}$ et un courant sélectionné $C_x$ :

[Math. 3]

$$C_{nom} = \frac{C_{v,ref}}{SOH_{ref}} = \frac{C_{v,x}}{SOH_x}$$

On peut donc déduire :

[Math. 4]

$$SOH_{ref} = SOH_x \left( \frac{C_{v,ref}}{C_{v,x}} \right)$$

Le rapport $C_{v,ref}/C_{v,x}$ peut être appelé « facteur correctif ». Par exemple, si on choisit comme valeur de courant de référence un courant faible $C_{ref} = C/3$ et comme valeur de courant sélectionné un courant fort $C_x = 4C$, on obtient l'équation suivante :

[Math. 5]

$$SOH_{C/3} = SOH_{4C} \left( \frac{C_{v,C/3}}{C_{v,4C}} \right)$$

On comprend donc qu'en effectuant une mesure de santé (SOH) d'une cellule sous courant fort (ici 4C) et donc par un essai rapide, il est possible, en appliquant le facteur correctif dont la valeur est donné par les résultats d'essais préalables de référence, d'obtenir une valeur de santé équivalente à celle qui aurait été obtenue par des essais sous courant faible (ici C/3) particulièrement longs. Dans l'exemple mis en oeuvre par la demanderesse, la décharge sous courant fort s'accomplie en environ 15 minutes. On comprend donc aisément que les durées sous courant fort sont particulièrement réduites par comparaison à des essais équivalents réalisés sous courants faibles sur les mêmes cellules.

À l'issu du procédé décrit ci-avant, on dispose donc d'un jeu de facteurs correctifs pour divers couples de régimes. Le jeu de facteurs forme alors un abaque de correspondance, ou convertisseur, entre des décharges sous au moins deux régimes différents, en particulier une décharge rapide et une décharge lente, pour une mesure d'usure d'au moins une cellule électrochimique. L'abaque peut prendre la forme d'un tableau à deux dimensions tel que celui représenté ci-après. Bien entendu, le lecteur comprend que l'abaque, ou jeu de données de conversion, peut être présenté sous d'autres formes, par exemple sous la forme de courbes telles que celles représentées en [Fig. 3] et [Fig. 4].

[Tableau 1]

| $C_{v,ref}/C_{v,x}$ | $C_{x1}$ | $C_{x2}$ | $C_{x3}$ | $C_{x4}$ |
|---|---|---|---|---|
| $C_{ref1}$ | | | | |
| $C_{ref2}$ | | | | |
| $C_{ref3}$ | | | | |

En [Fig. 3] sont représentées les évolutions de tensions (en Volts) au cours des décharges (temps en secondes) pour différents régimes de décharges. En [Fig. 4] sont représentées les évolutions de tensions (en Volts) en fonction de la capacité restituée électriquement (en Ampères.Heure) pour différents régimes de décharges. Les résultats expérimentaux représentés en [Fig. 3] et [Fig. 4] ont été obtenus pour une cellule de technologie Lithium-Ion et de type NMC (NMC pour « *Nickel Manganèse Cobalt* »). Pour cet exemple de cellule, les [Fig. 3] et [Fig. 4] forment chacun une représentation de l'abaque obtenu.

Les méthodes décrites ci-avant pour obtenir un abaque de conversion peuvent en soit être vues comme un premier procédé, l'abaque lui-même étant le résultat du premier. L'utilisation de l'abaque pour déterminer l'état d'usure d'une batterie peut quant à elle être vue comme un deuxième procédé. Le deuxième procédé est alors un procédé de détermination d'un état d'usure d'une cellule électrochimique.

Le procédé de détermination d'un état d'usure d'une cellule électrochimique comprend les opérations suivantes :

a. décharger la cellule électrochimique à un niveau de courant fort, par exemple 4C ;

b. mesurer le temps pour atteindre une tension électrique prédéterminée $V''_{min}$, par exemple une tension prédéterminée aux bornes considérée comme négligeable, et le courant électrique ;

c. comparer les résultats de la mesure (directement ou après conversion en d'autres grandeurs, par exemple sous la forme du temps mesuré de la décharge, de l'énergie restituée et/ou de la capacité restituée) à un abaque de correspondance entre une décharge rapide et une décharge lente d'une cellule électrochimique, par exemple un abaque obtenu selon le premier procédé ;

d. déduire de la comparaison un niveau d'usure de ladite au moins une cellule électrochimique sous un courant faible, par exemple C/3.

Le procédé de détermination d'un état d'usure d'une cellule électrochimique peut être mis en oeuvre au moyen d'un dispositif d'essai tel qu'un banc de mesure. Un tel banc de mesure est agencé de manière à pouvoir y connecter les bornes électriques d'une cellule électrochimique ou d'un ensemble de cellules électrochimiques. Le banc comprend un module de commande apte à imposer un courant et une tension choisis entre lesdites bornes et un module de mesure apte à mesurer le courant et la tension entre lesdites bornes. Le module de commande et le module de mesure sont conjointement agencés pour mettre en oeuvre le procédé de détermination d'un état d'usure d'une cellule électrochimique.

Pour la mise en oeuvre, le banc peut être piloté manuellement via une interface de commande du module de commande ou bien être piloté de manière au moins en partie automatisée. Dans le cas d'un pilotage automatisé, le banc peut comprendre un support d'enregistrement non transitoire lisible par un ordinateur sur lequel est enregistré un programme pour la mise en oeuvre du procédé de détermination d'un état d'usure d'une cellule électrochimique. Le support est accessible par un ordinateur, ou du moins un dispositif informatique, apte à mettre en oeuvre le programme.

Les innovations proposées rendent possible la diminution significative de la durée de décharge de mesure de la capacité résiduelle (par exemple de 3 heures à moins de 30 minutes) pour une cellule. Cela est applicable à des assemblages complexes de cellules formant des modules ou packs. Les opérations de démantèlement, complexes et coûteuses, deviennent superflues car il suffit d'accéder aux bornes électriques de la cellule ou de l'assemblage de cellules. Une mesure fiable et rapide de l'état de santé d'une cellule devient possible.

**Application industrielle**

L'invention peut trouver à s'appliquer notamment dans le contexte du contrôle de batteries usagées, par exemple pour en vérifier l'état avant de les affecter à un nouvel usage. Typiquement, les véhicules électriques tels que les automobiles fonctionnent avec des batteries de plusieurs centaines de cellules assemblées afin de fournir au moteur électrique une puissance suffisante et pour garantir une autonomie acceptable. Les performances des batteries s'amenuisent naturellement au fil de leur utilisation (vieillissement dit par cyclage) ou même hors utilisation (vieillissement dit calendaire). Pour les véhicules électriques, les vieillissements dépendent par exemple du type de cellules utilisées, de l'usage du véhicule, du climat, du lieu de garage, et même de la couleur du véhicule qui a une incidence sur la température du véhicule. La perte progressive de performance se traduit par une perte d'autonomie progressive et peu contrôlable (difficilement prédictible). Lorsque l'autonomie devient inacceptable, une nouvelle batterie remplace la précédente.

Une manière de recycler l'ancienne batterie est de la réutiliser dans un domaine pour lequel les performances réduites restent acceptables. Par exemple, les batteries usagées de véhicules peuvent être utilisés pour du stockage stationnaire de l'énergie électrique disponible sur un réseau, par exemple en combinaison avec des productions photovoltaïques intermittentes non prédictibles. De manière générale, de telles réaffectations d'usage s'inscrivent dans un objectif de construction d'une économie circulaire visée par l'union européenne. Pour cela il devient nécessaire de pouvoir effectuer un contrôle de performances de chaque batterie avant réaffectation, et ce selon un processus le plus rapide et le moins coûteux possible. Les innovations proposées ici participent à cet objectif.

L'invention ne se limite pas aux exemples de procédés, de bancs d'essais, de programmes informatiques et de supports d'enregistrement décrits ci-avant, seulement à titre d'exemple, mais elle englobe toutes les variantes que pourra envisager l'homme de l'art dans le cadre de la protection recherchée.

**Liste des signes de référence**

- 100 : séquence de conditionnement ;
- 101, 102, 103, 104 : opérations de séquence de conditionnement ;
- 200 : séquence de caractérisation ;
- 201, 202, 203, 204 : opérations de séquence de caractérisation ;
- 300 : phase de vieillissement ;
- C : courant électrique permettant la décharge totale de la cellule électrique en une heure ;
- $C_{nom}$ : Capacité nominale ;
- $C_{rea}$ : Capacité réelle ;
- $C_{ref}$ : courant de référence ;
- $C_x$ : courant sélectionné ;
- T1 : première durée ;
- T2 : deuxième durée ;
- T3 : troisième durée ; et
- T4 : quatrième durée.

**Revendications**

1. Procédé de construction d'un abaque de correspondance entre une décharge rapide et une décharge lente pour une mesure d'usure d'au moins une cellule électrochimique,

   le procédé comprenant une phase de mesure et une phase de vieillissement (300), la phase de mesure incluant elle-même une séquence de conditionnement (100) suivie d'une séquence de caractérisation (200) ;
   au cours de la séquence de conditionnement (100) les opérations suivantes étant mises en oeuvre :

   a. charger (101) l'au moins une cellule à un niveau de courant de référence ($C_{ref}$) jusqu'à atteindre une tension prédéterminée de fin de charge ($V_{max}$) ;
   b. relaxer (102) l'au moins une cellule pendant une première durée (T1) ;
   c. décharger (103) l'au moins une cellule au niveau de courant de référence ($C_{ref}$) jusqu'à atteindre une tension prédéterminée de fin de décharge ($V_{min}$) ;
   d. relaxer (104) l'au moins une cellule pendant une deuxième durée (T2) ;

au cours de la séquence de caractérisation (200), les opérations suivantes étant mises en oeuvre :

> i. charger (201) l'au moins une cellule au niveau de courant de référence (C_ref) jusqu'à atteindre une tension prédéterminée de fin de charge (V'_max) ;
> ii. relaxer (202) l'au moins une cellule pendant une troisième durée (T3) ;
> iii. décharger (203) l'au moins une cellule à un niveau de courant sélectionné (C_x) jusqu'à atteindre une tension prédéterminée de fin de décharge (V'_min) ;
> iv. relaxer (204) l'au moins une cellule pendant une quatrième durée (T4) ;

la séquence de caractérisation (200) étant réitérée au moins une fois en augmentant chaque fois la valeur dudit niveau de courant sélectionné (C_x) par rapport à l'itération précédente ;

le temps de chaque décharge étant mesuré de sorte que la capacité réelle (C_v) de la cellule peut être déduite à chaque décharge en fonction de l'intensité de chaque décharge et du temps de décharge mesuré ;

la phase de vieillissement (300) comprenant une alternance de charges et décharges dépourvue de relaxation intermédiaire et au niveau de courant de référence (C_ref) ;

la phase de mesure étant réitérée au moins une fois avec un niveau de courant de référence (C_ref) différent de celui de l'itération précédente, la phase de vieillissement (300) étant mise en oeuvre avant chaque réitération de la phase de mesure, de sorte qu'une capacité réelle (C_v) est obtenue pour une pluralité de couples de paramètres, chaque couple de paramètres incluant un niveau de courant sélectionnés (C_x) et un niveau de courant de référence (C_ref).

2. Procédé selon la revendication 1, dans lequel l'un au moins des niveaux de courant de référence (C_ref) est égal au tiers (C/3) du courant électrique (C) permettant la décharge totale de la cellule électrochimique en une heure.

3. Procédé selon l'une des revendications précédentes, dans lequel, d'une première séquence de caractérisation (200) à la dernière, la valeur dudit niveau de courant sélectionné (C_x) varie d'un courant faible inférieur ou égal au cinquième (C/5) du courant électrique (C) permettant la décharge totale de la cellule électrochimique jusqu'à un courant fort supérieur ou égal au quintuple (5C) du courant électrique (C) permettant la décharge totale de la cellule électrochimique.

4. Procédé selon l'une des revendications précédentes, dans lequel les durées de relaxation (T1, T2, T3, T4) sont inférieures ou égales à 120 minutes.

5. Procédé selon l'une des revendications précédentes, dans lequel la capacité réelle (C_v) de la cellule est déduite à chaque décharge par multiplication de l'intensité de chaque décharge par le temps de décharge mesuré ou par application de l'équation suivante :

[Math. 2]

$$C_V = \int_t i(t) \times dt$$

6. Procédé de détermination d'un état d'usure d'une cellule électrochimique comprenant les opérations suivantes :

> a. décharger ladite cellule électrochimique à un niveau de courant fort ;
> b. mesurer le temps et le courant électrique pour atteindre une tension électrique (V''_min) prédéterminée ;
> c. comparer les résultats de la mesure à un abaque de correspondance entre une décharge rapide et une décharge lente d'une cellule électrochimique établi conformément à l'une des revendications précédentes ;
> d. déduire de la comparaison un niveau d'usure de ladite au moins une cellule électrochimique sous un courant faible.

7. Procédé selon la revendication 6, dans lequel le niveau de courant fort est supérieur au tiers (C/3) du courant électrique (C) permettant la décharge totale de la cellule électrique en une heure et dans lequel le niveau de courant faible est inférieur ou égal au tiers (C/3) du courant électrique (C) permettant la décharge totale de la cellule électrique en une heure.

**8.** Banc d'essai agencé de manière à pouvoir y connecter les bornes électriques d'une cellule électrochimique ou d'un ensemble de cellules électrochimiques, ledit banc comprenant un module de commande apte à imposer un courant et une tension choisies entre lesdites bornes et un module de mesure apte à mesurer le courant et la tension entre lesdites bornes, le module de commande et le module de mesure étant conjointement agencés pour mettre en oeuvre l'un au moins des procédés selon l'une des revendications précédentes.

**9.** Programme informatique comportant des instructions pour la mise en oeuvre d'un procédé selon l'une des revendications 1 à 7 lorsque ce programme est exécuté par un processeur.

**10.** Support d'enregistrement non transitoire lisible par un ordinateur sur lequel est enregistré un programme pour la mise en oeuvre du procédé selon l'une des revendications 1 à 7 lorsque ce programme est exécuté par un processeur.

**Patentansprüche**

**1.** Verfahren für ein Erstellen eines Korrespondenzdiagramms zwischen einer schnellen Entladung und einer langsamen Entladung für eine Messung eines Verschleißes von wenigstens einer elektrochemischen Zelle,

wobei das Verfahren eine Messphase und eine Alterungsphase (300) umfasst, wobei die Messphase selbst eine Konditionierungssequenz (100) umfasst, auf welche eine Charakterisierungssequenz (200) folgt; wobei während der Konditionierungssequenz (100) die folgenden Vorgänge ausgeführt werden:

a. Laden (101) der wenigstens einen Zelle mit einem Referenz-Strompegel ($C_{ref}$), bis eine vorbestimmte Lade-Endspannung ($V_{max}$) erreicht wird;
b. Entspannen (102) der wenigstens einen Zelle während einer ersten Zeitdauer (T1);
c. Entladen (103) der wenigstens einen Zelle mit dem Referenz-Strompegel ($C_{ref}$), bis eine vorbestimmte Entlade-Endspannung ($V_{min}$) erreicht wird;
d. Entspannen (104) der wenigstens einen Zelle während einer zweiten Zeitdauer (T2);

wobei während der Charakterisierungssequenz (200) die folgenden Vorgänge durchgeführt werden:

i. Laden (201) der wenigstens einen Zelle mit dem Referenz-Strompegel ($C_{ref}$), bis eine vorbestimmte Lade-Endspannung ($V'_{max}$) erreicht wird;
ii. Entspannen (202) der wenigstens einen Zelle während einer dritten Zeitdauer (T3);
iii. Entladen (203) der wenigstens einen Zelle mit einem ausgewählten Strompegel ($C_x$), bis eine vorbestimmte Entlade-Endspannung ($V'_{min}$) erreicht wird;
iv. Entspannen (204) der wenigstens einen Zelle während einer vierten Zeitdauer (T4);

wobei die Charakterisierungssequenz (200) wenigstens einmal wiederholt wird, wobei jedes Mal der Wert des ausgewählten Strompegels ($C_x$) bezüglich der vorhergehenden Iteration erhöht wird;
wobei die Zeit jeder Entladung derart gemessen wird, dass die tatsächliche Kapazität ($C_v$) der Zelle bei jeder Entladung als Funktion der Intensität von jeder Entladung und der gemessenen Entladezeit abgeleitet werden kann;
wobei die Alterungsphase (300) ein Abwechseln von Ladungen und Entladungen ohne zwischenzeitliche Entspannung und mit dem Referenz-Strompegel ($C_{ref}$) umfasst;
wobei die Messphase wenigstens einmal mit einem Referenz-Strompegel ($C_{ref}$) wiederholt wird, welcher verschieden von demjenigen der vorhergehenden Iteration ist, wobei die Alterungsphase (300) vor jeder neuen Iteration der Messphase derart ausgeführt wird, dass eine tatsächliche Kapazität ($C_v$) für eine Mehrzahl von Parameterpaaren erhalten wird, wobei jedes Parameterpaar einen ausgewählten Strompegel ($C_x$) und einen Referenz-Strompegel ($C_{ref}$) umfasst.

**2.** Verfahren nach Anspruch 1, wobei der wenigstens eine Referenz-Strompegel ($C_{ref}$) gleich einem Drittel (C/3) des elektrischen Stroms (C) ist, welcher die vollständige Entladung der elektrochemischen Zelle in einer Stunde erlaubt.

**3.** Verfahren nach einem der vorhergehenden Ansprüche, wobei von einer ersten Charakterisierungssequenz (200) bis zu der letzten der Wert des ausgewählten Strompegels ($C_x$) von einem schwachen Strom, kleiner oder gleich einem Fünftel (C/5) des elektrischen Stroms (C), welcher die vollständige Entladung der elektrochemischen Zelle erlaubt, bis zu einem starken Strom variiert, größer oder gleich dem Fünffachen (5C) des elektrischen Stroms (C), welcher die vollständige Entladung der elektrochemischen Zelle erlaubt.

4. Verfahren nach einem der vorhergehenden Ansprüche, wobei die Zeitdauern der Entspannung (T1, T2, T3, T4) kleiner oder gleich 120 Minuten sind.

5. Verfahren nach einem der vorhergehenden Ansprüche, wobei die tatsächliche Kapazität ($C_v$) der Zelle bei jeder Entladung durch Multiplikation der Intensität von jeder Entladung mit der gemessenen Entladezeit oder durch Anwendung der folgenden Gleichung abgeleitet wird:

[Math. 2]

$$C_v = \int_t i(t) \times dt$$

6. Verfahren für ein Bestimmen eines Verschleißzustands einer elektrochemischen Zelle, umfassend die folgenden Vorgänge:

a. Entladen der elektrochemischen Zelle bei einem starken Strompegel;
b. Messen der Zeit und des elektrischen Stroms für ein Erreichen einer vorbestimmten elektrischen Spannung ($V''_{min}$);
c. Vergleichen der Ergebnisse der Messung mit einem Korrespondenzdiagramm zwischen einer schnellen Entladung und einer langsamen Entladung einer elektrochemischen Zelle, welches entsprechend einem der vorhergehenden Ansprüche erstellt worden ist;
d. Ableiten des Vergleichs eines Verschleißniveaus der wenigstens einen elektrochemischen Zelle unter einem schwachen Strom.

7. Verfahren nach Anspruch 6, wobei der starke Strompegel größer als ein Drittel (C/3) des elektrischen Stroms (C) ist, welcher das vollständige Entlader der elektrischen Zelle in einer Stunde ermöglicht, und wobei der schwache Strompegel kleiner oder gleich einem Drittel (C/3) des elektrischen Stroms (C) ist, welcher das vollständige Entladen der elektrischen Zelle in einer Stunde ermöglicht.

8. Prüfstand, welcher derart eingerichtet ist, dass er die elektrischen Anschlüsse einer elektrochemischen Zelle oder einer Anordnung von elektrochemischen Zellen verbinden kann, wobei der Stand ein Steuermodul umfasst, welches in der Lage ist, einen ausgewählten Strom und eine ausgewählte Spannung zwischen den Anschlüssen anzulegen, sowie ein Messmodul, welches in der Lage ist, den Strom und die Spannung zwischen den Anschlüssen zu messen, wobei das Steuermodul und das Messmodul gemeinschaftlich dazu eingerichtet sind, wenigstens ein Verfahren nach einem der vorhergehenden Ansprüche auszuführen.

9. Computerprogramm, umfassend Anweisungen für das Ausführen eines Verfahrens nach einem der Ansprüche 1 bis 7, wenn das Programm von einem Prozessor ausgeführt wird.

10. Nichtflüchtiger Datenspeicher, welcher von einem Computer lesbar ist, auf welchem ein Programm zum Ausführen des Verfahrens nach einem der Ansprüche 1 bis 7 gespeichert ist, wenn das Programm von einem Prozessor ausgeführt wird.

**Claims**

1. A method for constructing a chart of correspondence between a quick discharge and a slow discharge for measuring the wear of at least one electrochemical cell,

the method comprising a measuring phase and an ageing phase (300), the measuring phase including in turn a training sequence (100) followed by a characterisation sequence (200);
during the training sequence (100), the following operations being implemented:

a. charging (101) the at least one cell at a reference current level ($C_{ref}$) until reaching a predetermined end-of-charge voltage ($V_{max}$);
b. relaxing (102) the at least one cell for a first duration (T1);
c. discharging (103) the at least one cell at the reference current level ($C_{ref}$) until reaching a predetermined end-of-discharge voltage ($V_{min}$);
d. relaxing (104) the at least one cell for a second duration (T2);

during the characterisation sequence, the following operations being implemented:

i. charging (201) the at least one cell at the reference current level ($C_{ref}$) until reaching a predetermined end-of-charge voltage ($V'_{max}$);
ii. relaxing (202) the at least one cell for a third duration (T3);
iii. discharging (203) the at least one cell at a selected current level until reaching a predetermined end-of-discharge voltage ($V'_{min}$);
iv. relaxing (204) the at least one cell for a fourth duration (T4);

the characterisation sequence (200) being reiterated at least once while increasing, each time, the value of said selected current level ($C_x$) with respect to the previous iteration;
the time of each discharge being measured so that the actual capacity ($C_v$) of the cell can be deduced at each discharge according to the intensity of each discharge and the measured discharge time;
the ageing phase (300) comprising an alternation of charges and discharges with no intermediate relaxation and at the reference current level ($C_{ref}$);
the measuring phase being reiterated at least once with a reference current level ($C_{ref}$) different from that of the previous iteration, the ageing phase (300) being implemented before each reiteration of the measuring phase, so that an actual capacity ($C_v$) is obtained for a plurality of pairs of parameters, each pair of parameters including a selected current level ($C_x$) and a reference current level ($C_{ref}$).

2. The method according to claim 1, wherein at least one amongst the reference current levels ($C_{ref}$) is equal to one-third (C/3) of the electric current (C) enabling total discharge of the electrochemical cell in one hour.

3. The method according to one of the preceding claims, wherein, from a first characterisation sequence (200) to the last one, the value of said selected current level ($C_x$) varies from a weak current lower than or equal to one-fifth (C/5) of the electric current (C) enabling total discharge of the electrochemical cell, up to a strong current higher than or equal to five times (5C) the electric current (C) enabling total discharge of the electrochemical cell.

4. The method according to one of the preceding claims, wherein the relaxation durations (T1, T2, T3, T4) are shorter than or equal to 120 minutes.

5. The method according to one of the preceding claims, wherein the actual capacity ($C_v$) of the cell is deduced at each discharge by multiplying the intensity of each discharge by the measured discharge time or by applying the following equation:

[Math. 2]

$$C_V = \int_t i(t)\, x\, dt$$

6. A method of determining a state of wear of an electrochemical cell, comprising the following operations:

a. discharging said electrochemical cell at a strong current level;
b. measuring the time and the electric current to reach a predetermined electric voltage ($V''_{min}$);
c. comparing the results of the measurement with a chart of correspondence between a quick discharge and a slow discharge of an electrochemical cell established in accordance with one of the preceding claims;
d. deducing from the comparison a level of wear of said at least one electrochemical cell under a weak current.

7. The method according to claim 6, wherein the strong current level is higher than one-third (C/3) of the electric current (C) enabling total discharge of the electric cell in one hour, and wherein the weak current level is lower than or equal to one-third (C/3) of the electric current (C) enabling total discharge of the electric cell in one hour.

8. A test bench arranged so as to be able to connect thereto the electrical terminals of an electrochemical cell or of a set of electrochemical cells, said bench comprising a control module able to impose selected current and voltage between said terminals and a measuring module able to measure the current and voltage between said terminals, the control module and the measuring module being arranged so as to implement together at least one of the methods according to one of the preceding claims.

9. A computer program including instructions for the implementation of a method according to one of claims 1 to 7 when this program is executed by a processor.

10. A non-transitory computer-readable storage medium on which a program is recorded for the implementation of the method according to one of claims 1 to 7 when this program is executed by a processor.

[Fig. 1]

# Fig. 1

[Fig. 2]

Fig. 2

[Fig. 3]

# Fig. 3

[Fig. 4]

# Fig. 4

**EP 3 899 561 B1**

## RÉFÉRENCES CITÉES DANS LA DESCRIPTION

**Documents brevets cités dans la description**

- FR 3020142 A1

- EP 2746797 A1